# FASCICULE DE BREVET EUROPEEN

(11) **EP 3 775 330 B1**
(45) Date de publication et mention de la délivrance du brevet: **26.02.2025**
(21) Numéro de dépôt: 19721380.4
(22) Date de dépôt: 26.03.2019
(51) Int. Cl.: C30B 23/02, C30B 25/18, C30B 29/42, H01L 21/762

(54) **PROCÉDÉ DE FABRICATION D'UNE COUCHE MONOCRISTALLINE DE MATÉRIAU GAAS ET SUBSTRAT POUR CROISSANCE PAR ÉPITAXIE D'UNE COUCHE MONOCRISTALLINE DE MATÉRIAU GAAS**
VERFAHREN ZUR HERSTELLUNG EINER MONOKRISTALLINEN SCHICHT AUS GAAS-MATERIAL UND SUBSTRAT ZUM EPITAKTISCHEN WACHSTUM EINER MONOKRISTALLINEN SCHICHT AUS GAAS-MATERIAL
METHOD FOR MANUFACTURING A MONOCRYSTALLINE LAYER OF GAAS MATERIAL AND SUBSTRATE FOR EPITAXIAL GROWTH OF A MONOCRYSTALLINE LAYER OF GAAS MATERIAL

(30) Priorité: 28.03.2018 FR 1800252
(43) Date de publication de la demande: 17.02.2021
(73) Titulaire: SOITEC, 38190 Bernin (FR)
(72) Inventeur: GHYSELEN, Bruno, 38170 Seyssinet (FR)
(74) Mandataire: Grünecker Patent- und Rechtsanwälte PartG mbB
(86) Numéro de dépôt international: PCT/IB2019/000207
(87) Numéro de publication internationale: WO 2019/186268

(56) Documents cités:
- US-A1- 2015 041 853
- FUJIOKA H ET AL: "Epitaxial growth of semiconductors on SrTiO"3 substrates", JOURNAL OF CRYSTAL GR, ELSEVIER, AMSTERDAM, NL, vol. 229, no. 1-4, 1 July 2001 (2001-07-01), pages 137 - 141, XP004251044, ISSN: 0022-0248, DOI: 10.1016/S0022-0248(01)01108-3
- EISENBEISER K ET AL: "GaAs MESFETs fabricated on Si substrates using a SrTiO 3 buffer layer", IEEE ELECTRON DEVICE LETTERS, IEEE SERVICE CENTER, NEW YORK, NY, US, vol. 23, no. 6, 1 June 2002 (2002-06-01), pages 300 - 302, XP011430643, ISSN: 0741-3106, DOI: 10.1109/LED.2002.1004215

## Description

### DOMAINE DE L'INVENTION

La présente invention concerne un procédé de fabrication d'une couche monocristalline de matériau GaAs ainsi qu'un substrat pour la croissance par épitaxie d'une telle couche monocristalline de matériau GaAs.

### ETAT DE LA TECHNIQUE

Certains matériaux ne sont pas actuellement disponibles sous forme de substrat monocristallin en forme de tranche en grand diamètre. Et certains matériaux sont éventuellement disponibles en grand diamètre mais pas selon certaines caractéristiques ou spécifications en terme de qualité, en particulier vis-à-vis la densité de défauts ou encore les propriétés électriques ou optiques requises.

US 2015/041853 décrit un procédé de croissance d'InGaAs sur une couche de SrTiO3 après transfert d'une autre couche d'InGaAs ensemble avec une couche de SrTiO3 sur un substrat porteur, le substrat porteur étant en silicium. Le transfert est effectué par implantation ionique et détachement puis amincissement comprenant l'enlèvement de l'autre couche d'InGaAs.

### EXPOSE DE L'INVENTION

La présente invention vise à pallier ces limitations de l'état de la technique en proposant un procédé de fabrication d'une couche monocristalline de matériau GaAs ainsi qu'un substrat pour la croissance par épitaxie d'une telle couche monocristalline de matériau GaAs. Par ceci il est possible de remédier au problème de taille des substrats monocristallins de matériau GaAs actuellement disponibles.

L'invention concerne un procédé de fabrication d'une couche monocristalline de matériau GaAs selon la revendication 1.

Dans des modes de réalisation avantageux la couche germe monocristalline a une épaisseur inférieure à 10 µm, de préférence inférieure à 2 µm, et plus préférentiellement inférieure à 0,2µm.

Dans des modes de réalisation avantageux l'étape d'amincissement comprend la formation d'une zone de fragilisation délimitant une portion du substrat monocristallin de matériau SrTiO₃ destinée à être transférée sur le substrat support de matériau silicium.

Dans des modes de réalisation avantageux la formation de la zone de fragilisation est obtenue par implantation d'espèces atomiques et/ou ioniques.

Dans des modes de réalisation avantageux l'étape d'amincissement comprend un détachement au niveau de la zone de fragilisation de manière à transférer ladite portion du substrat monocristallin de matériau SrTiO₃ sur le substrat support de matériau silicium, en particulier le détachement comprend l'application d'une contrainte thermique et/ou mécanique.

Dans des modes de réalisation avantageux l'étape d'assemblage est une étape d'adhésion moléculaire.

Dans des modes de réalisation avantageux la couche de germe monocristalline de matériau SrTiO₃ se présente sous la forme d'une pluralité de pavés transférés chacun sur le substrat support de matériau silicium.

Dans des modes de réalisation avantageux le substrat support de matériau silicium comprend une interface démontable configurée pour être démontée par une attaque chimique et/ou par une sollicitation mécanique.

Un example de réalisation, ne correspondant pas à l'invention mais nécessaire pour sa compréhension, concerne aussi un substrat pour croissance par épitaxie d'une couche monocristalline de matériau GaAs caractérisé en ce qu'il comprend une couche germe monocristalline de matériau SrTiO₃ sur un substrat support de matériau silicium.

Dans des examples de réalisation avantageux la couche germe monocristalline de matériau SrTiO₃ se présente sous la forme d'une pluralité de pavés.

Dans des exemples de réalisation avantageux le substrat support de matériau silicium comprend une interface démontable configurée pour être démontée par une attaque chimique et/ou par une sollicitation mécanique.

L'invention concerne aussi un procédé de fabrication d'une couche monocristalline de matériau AlₓIn_{y}Ga_{z}AsᵢPₘNₙ ayant un paramètre de maille proche de celui du matériau GaAs comprenant le transfert d'une couche germe monocristalline de matériau SrTiO₃ sur un substrat support de matériau silicium suivi d'une croissance par épitaxie d'une couche monocristalline de matériau AlₓIn_{y}Ga_{z}AsᵢPₘNₙ.

L'invention concerne aussi un procédé de fabrication d'une couche monocristalline de matériau AlₓIn_{y}Ga_{z}AsᵢPₘNₙ ayant un paramètre de maille proche de celui du matériau GaAs comprenant le transfert d'une couche germe monocristalline de matériau YSZ ou CeO₂ ou MgO ou Al₂O₃, sur un substrat support de matériau silicium suivi d'une croissance par épitaxie d'une couche monocristalline de matériau AlₓIn_{y}Ga_{z}AsᵢPₘNₙ.

### DESCRIPTION DES FIGURES

D'autres caractéristiques et avantages de l'invention seront mieux compris à la lecture de la description détaillée qui va suivre, en référence aux dessins annexés sur lesquels :

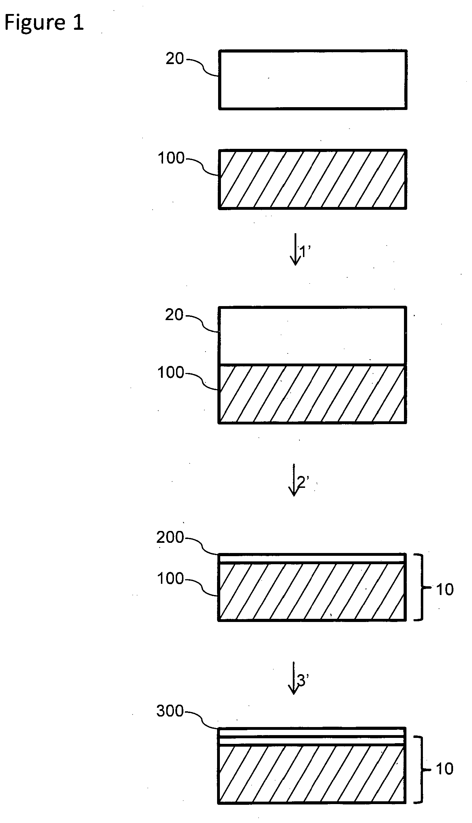

- La figure 1 illustre un procédé de fabrication d'une couche monocristalline de matériau GaAs selon un mode de réalisation de l'invention ainsi qu'un substrat pour la croissance par épitaxie d'une telle couche monocristalline de matériau GaAs selon ce mode de réalisation de l'invention ;

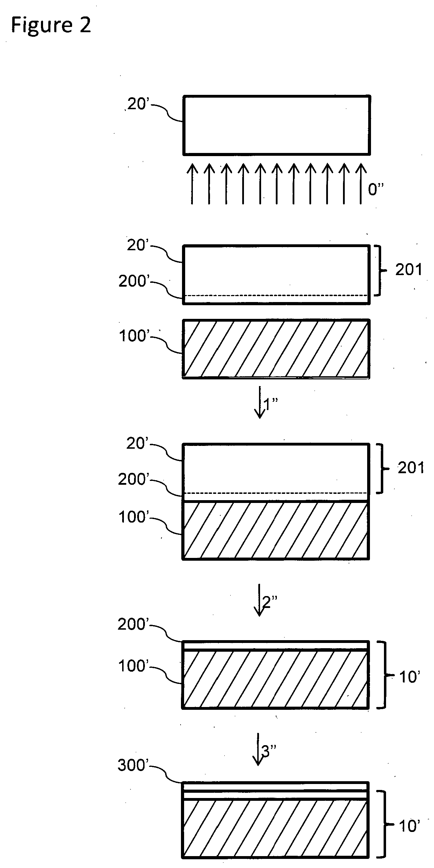

- La figure 2 illustre un procédé de fabrication d'une couche monocristalline de matériau GaAs selon un autre mode de réalisation de l'invention ainsi qu'un substrat pour la croissance par épitaxie d'une telle couche monocristalline de matériau GaAs selon cet autre mode de réalisation de l'invention ;

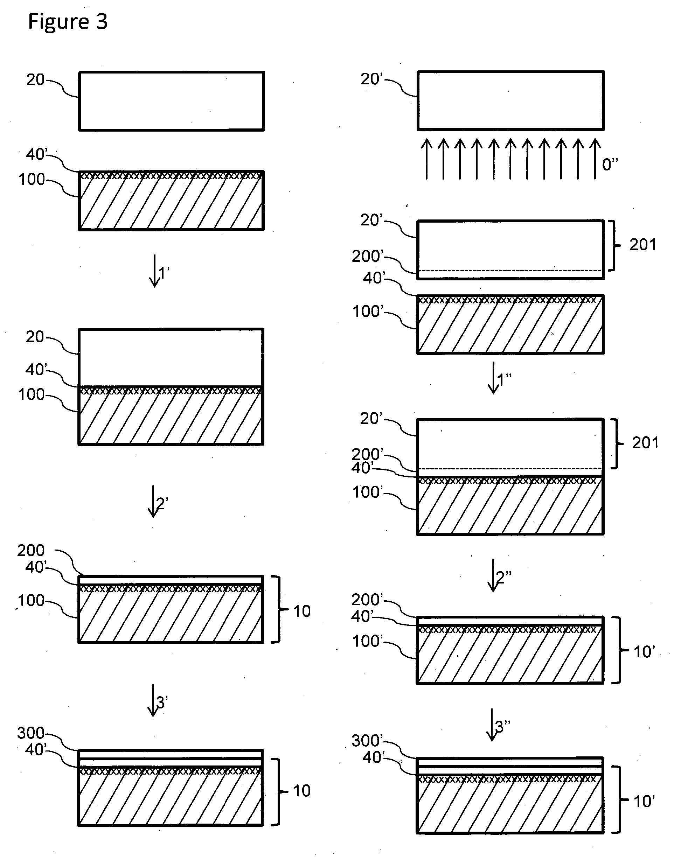

- La figure 3 illustre un procédé de fabrication d'une couche monocristalline de matériau GaAs selon encore un autre mode de réalisation de l'invention ainsi qu'un substrat pour la croissance par épitaxie d'une telle couche monocristalline de matériau GaAs selon cet autre mode de réalisation de l'invention ;

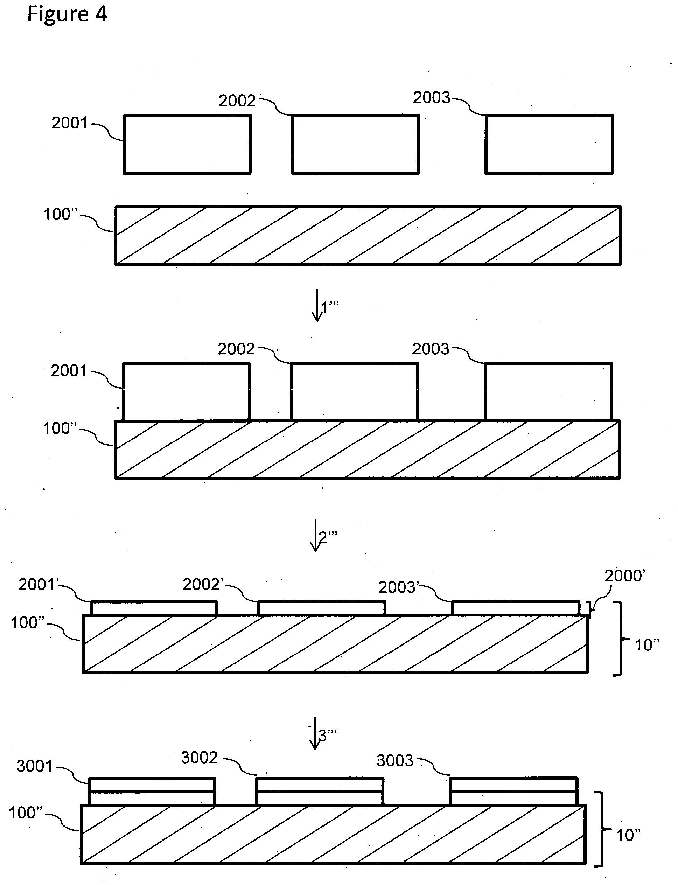

- La figure 4 illustre un procédé de fabrication d'une couche monocristalline de matériau GaAs selon encore un autre mode de réalisation de l'invention ainsi qu'un substrat pour la croissance par épitaxie d'une telle couche monocristalline de matériau GaAs selon cet autre mode de réalisation de l'invention ;

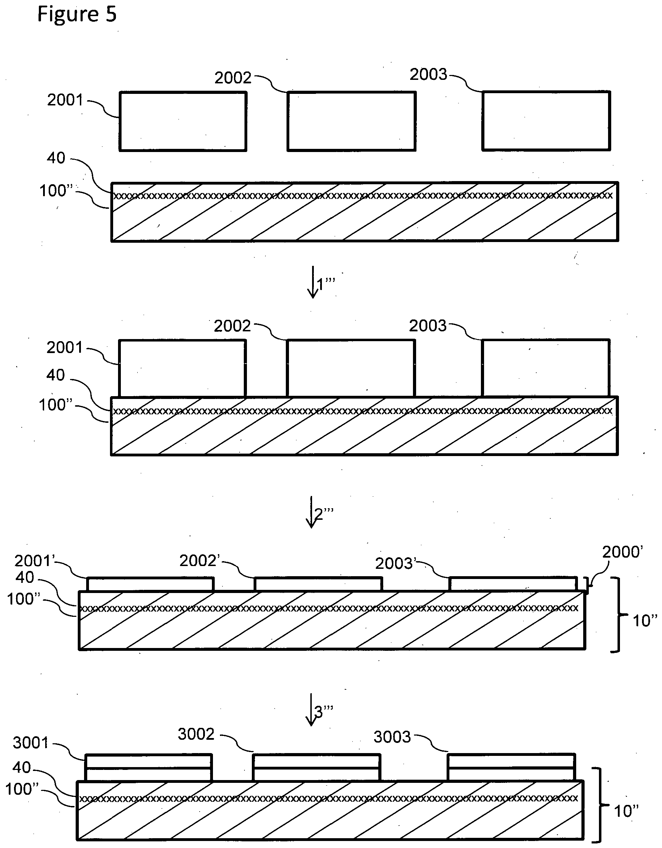

- La figure 5 illustre un procédé de fabrication d'une couche monocristalline de matériau GaAs selon encore un autre mode de réalisation de l'invention ainsi qu'un substrat pour la croissance par épitaxie d'une telle couche monocristalline de matériau GaAs selon cet autre mode de réalisation de l'invention ;

Pour favoriser la lisibilité des figures, les différentes couches ne sont pas nécessairement représentées à l'échelle.

### DESCRIPTION DETAILLEE DE MODES DE REALISATION DE L'INVENTION

La figure 1 illustre un substrat support 100 de matériau silicium sur lequel on transfère une couche germe monocristalline 200 de matériau SrTiO₃. D'autres matériaux de la couche germe monocristalline 200 peuvent être envisagés tels que YSZ, CeO₂, MgO ou Al₂O₃, ces derniers ayant un paramètre de maille proche de celui du matériau GaAs. Le substrat support 100 de matériau silicium peut aussi être remplacé par un substrat support 100 de matériau saphir, Ni ou Cu. L'utilisation du silicium a l'avantage d'ouvrir le champ d'application des films de matériau GaAs non seulement a des équipements de grande taille type 300 mm mais aussi rendre compatible l'industrie microélectronique pour laquelle les exigences en terme d'acceptance sur la ligne de production de matériau exotique autre que silicium, en particulier GaAs, sont élevées. L'étape d'assemblage 1' de la couche germe monocristalline 200 de matériau SrTiO₃ sur le substrat support 100 de matériau silicium se fait préférentiellement par une étape d'adhésion moléculaire. Cette étape d'adhésion moléculaire comprend une étape de collage, préférentiellement à température ambiante, et est suivie d'un recuit de consolidation de l'interface de collage qui se fait usuellement à des températures élevées jusqu'à 900°C voire 1100°C pendant une durée de quelques minutes à quelques heures.

La figure 1 représente schématiquement l'étape d'assemblage 1' d'un substrat monocristallin 20 de matériau SrTiO₃ sur le substrat support 100 de matériau silicium. Il suit une étape d'amincissement 2' du substrat monocristallin 20 de matériau SrTiO₃ après avoir été assemblé sur le substrat support 100 de matériau silicium. La figure 1 représente schématiquement l'étape d'amincissement 2' qui peut être mise en œuvre par exemple par gravure chimique et/ou mécanique (polissage, meulage, fraisage, ..). Ainsi on peut obtenir la couche germe monocristalline 200 de matériau SrTiO₃ qui va servir comme germe monocristalline d'une étape de croissance 3' par épitaxie de la couche monocristalline 300 de matériau GaAs faite sur le substrat pour croissance par épitaxie d'une couche monocristalline de matériau GaAs 10 représenté schématiquement dans la figure 1. L'homme de métier saurait ajuster les paramètres utilisés pour une croissance par épitaxie de la couche monocristalline de matériau GaAs usuellement utilisé lors d'une homoépitaxie ou hétéroépitaxie sur un substrat bulk monocristallin afin d'optimiser l'étape de croissance 3' par épitaxie de la couche monocristalline 300 de matériau GaAs faite sur le substrat pour croissance par épitaxie d'une couche monocristalline de matériau GaAs 10 de la présente invention. L'épitaxie du matériau GaAs se fait donc par MOCVD ou MBE à des températures usuelles entre 550 et 700 °C en utilisant des précurseurs connus par l'homme de métier. La présente invention n'est d'ailleurs pas limitée à une épitaxie du matériau GaAs mais s'étend à certains composites de type AlₓIn_{y}Ga_{z}AsᵢPₘNₙ ayant un paramètre de maille proche de celui du matériau GaAs.

La figure 2 représente schématiquement un mode de réalisation du procédé de fabrication d'une couche monocristalline de matériau GaAs qui se différencie du mode de réalisation décrit en lien avec la figure 1 en ce que le substrat monocristallin 20' de matériau SrTiO₃ subit une étape d'implantation 0" d'espèces atomiques et/ou ioniques afin de former une zone de fragilisation délimitant une portion 200' du substrat monocristallin 20' de matériau SrTiO₃ destinée à être transférée sur le substrat support 100' de matériau silicium, et en ce que l'étape d'amincissement 2" comprend un détachement au niveau de cette zone de fragilisation de manière à transférer ladite portion 200' du substrat monocristallin 20' de matériau SrTiO₃ sur le substrat support 100' de matériau silicium, en particulier ce détachement comprend l'application d'une contrainte thermique et/ou mécanique. L'avantage de ce mode de réalisation est ainsi de pouvoir récupérer la partie restante 201 du substrat monocristallin 20' de matériau SrTiO₃ de départ qu'on peut ainsi utiliser de nouveau pour faire subir le même procédé de nouveau et ainsi réduire les coûts. Le substrat pour croissance par épitaxie d'une couche monocristalline de matériau GaAs 10' ainsi illustré dans la figure 2 sert pour l'étape de croissance 3" de la couche monocristalline 300' de matériau GaAs comme déjà décrit lors du procédé décrit en lien avec la figure 1. De manière générale l'étape d'implantation 0" se fait avec des ions hydrogène. Une alternative intéressante bien connue de l'homme de l'art consiste à remplacer tout ou partie des ions hydrogène par des ions helium. Une dose d'implantation d'hydrogène sera typiquement comprise entre 6×10¹⁶ cm⁻² et 1×10¹⁷ cm⁻². L'énergie d'implantation, sera typiquement comprise entre entre 50 à 170 keV. Ainsi le détachement se fait typiquement à des températures entre 300 et 600°C. On obtient ainsi des épaisseurs de la couche germe monocristalline de l'ordre de 200 nm à 1,5 µm. Juste après l'opération de détachement, des étapes technologiques additionnelles sont avantageusement ajoutées dans le but soit de renforcer l'interface de collage, soit de récupérer une bonne rugosité, soit de guérir les défauts éventuellement générés pendant l'étape d'implantation ou encore pour préparer la surface de la couche germe à la reprise d'épitaxie. Ces étapes sont par exemple un polissage, une gravure chimique (humide ou sèche), un recuit, un nettoyage chimique. Ils peuvent être utilisés seuls ou en combinaison que l'homme de l'art saura ajuster.

La figure 3 se différencie des modes de réalisation décrits en lien avec la figure 1 et figure 2 en ce que le substrat pour croissance par épitaxie d'une couche monocristalline de matériau GaAs (10, 10') comprend une interface démontable 40' configurée pour être démontée. Dans le cas d'un substrat support 100 de matériau silicium il peut s'agir d'une surface rugueuse par exemple du matériau silicium assemblée avec la couche germe monocristalline lors de l'étape d'assemblage. Ou encore une interface rugueuse peut être présente au sein du substrat support 100 de matériau silicium, ce dernier par exemple obtenu par assemblage de deux plaques de silicium. Un autre mode de réalisation serait d'introduire au niveau de la face à assembler avec la couche germe monocristalline une couche de silicium poreux susceptible de fracturer lors de l'application d'une contrainte mécanique et/ou thermique, par exemple par insertion d'une lame au bord de plaque connu par l'homme de métier ou encore par l'application d'un recuit. Bien évidemment cette interface est choisie de sorte à résister aux autres contraintes mécaniques et/ou thermiques subies lors du procédé de la présente invention (p.ex. détachement, croissance par épitaxie,...). L'homme de métier saura identifier d'autres méthodes de réalisations de cette interface démontable. Ces différentes configurations de démontage permettent ainsi soit un report de la couche épitaxiée sur un support final qui n'est pas compatible avec les paramètres de croissance soit la préparation d'un film épais de matériau GaAs de type autoporté.

La figure 4 représente schématiquement un mode de réalisation du procédé de fabrication d'une couche monocristalline de matériau GaAs qui se différencie des modes de réalisation décrits en lien avec la figure 1, la figure 2 et la figure 3 en ce que la couche de germe monocristalline 2000' de matériau SrTiO₃ se présente sous la forme d'une pluralité de pavés (2001', 2002', 2003') transférés chacun sur le substrat support 100" de matériau silicium. Les différents pavés peuvent se présenter sous une forme quelconque (carré, hexagonale, bandes,...) et avec des tailles différentes variant de quelques mm² à plusieurs cm². L'espacement entre les puces peut également varier significativement selon que l'on cherche une densité maximum de couverture (dans ce cas on choisira préférentiellement un espacement inférieur à 0,2 mm) ou au contraire une dissémination maximum des pavés au sein du substrat (dans ce cas l'espacement peut être de plusieurs millimètres et même centimètres). Pour chaque pavé l'homme de métier saurait appliquer le transfert qu'il souhaite et n'est pas limité à une méthode particulière. Ainsi on pourrait envisager d'appliquer les renseignements techniques décrits en lien avec le procédé illustré schématiquement dans la figure 1 ou les renseignements techniques décrits en lien avec le procédé illustré schématiquement dans la figure 2 , voir même une combinaison des deux. Ainsi il est possible d'assembler 1‴ des substrats monocristallins (2001, 2002, 2003) de matériau SrTiO₃ qui ont une taille inférieure à la taille du substrat support 100" afin de créer par amincissement 2‴ sur ce dernier les couches germe monocristallines (2001', 2002', 2003') pour la croissance par épitaxie 3‴ d'une couche monocristalline (3001, 3002, 3003) de matériau GaAs sur chaque pavé du substrat pour croissance par épitaxie d'une couche monocristalline de matériau GaAs 10".

Les différents modes de réalisation décrites en lien avec les figures 1 à 4 ouvrent ainsi la possibilité de co-intégration de composants faits dans la couche monocristalline de matériau GaAs avec des composants fait dans le substrat support de matériau silicium. Ce dernier peut être simplement un substrat silicium mais il peut aussi s'agir d'un substrat de type SOI comprenant une couche d'oxyde de silicium séparant un substrat silicium d'une couche fine de silicium. Dans le cas des modes de réalisation décrits en lien avec les figures 1 à 4 l'accès au substrat support peut se faire simplement par lithographie et gravure connu par l'homme de métier. Dans le cas du mode de réalisation décrit en lien avec la figure 4 on peut aussi simplement choisir les emplacements des pavés ainsi que leur espacement.

La figure 5 représente schématiquement un mode de réalisation qui se différencie du mode de réalisation décrit en lien avec la figure 4 en ce que le substrat support 100" ainsi que par la suite le substrat pour croissance par épitaxie de la couche monocristalline de matériau GaAs 10" comprend une interface démontable 40 configurée pour être démontée, par exemple par une attaque chimique et/ou par une sollicitation mécanique. Ceci permettrait d'enlever une partie du substrat support 100" comme déjà évoqué en lien avec la figure 3. Un exemple serait l'utilisation d'un substrat support 100 de type SOI comprenant une couche d'oxyde de silicium séparant un substrat silicium d'une couche fine de silicium. Cette couche d'oxyde pourrait être utilisée comme interface démontable 40 par une gravure sélective de cette couche d'oxyde, par exemple par immersion dans un bain d'acide fluorhydrique (HF). Cette option de démontage par gravure chimique d'une couche enterrée est particulièrement intéressante lorsqu'elle vient en combinaison du traitement d'une pluralité de petits substrats. En effet, le rayon d'action des sous-gravures est généralement limité à quelques centimètres voire quelques millimètres si l'on souhaite conserver des conditions et des temps de traitement industriellement raisonnables. Le traitement d'une pluralité de petits substrats autorise le démarrage de plusieurs fronts de gravure chimique grâce à un accès possible de la couche enterrée entre chaque pavé, et non plus seulement sur les bords extrêmes des substrats qui peuvent aller jusqu'à 300mm de diamètre. Dans le cas d'un substrat support de type SOI il est ainsi possible d'enlever en partie la couche fine de silicium entre les pavés afin de permettre le démarrage de plusieurs fronts de gravure.

La fine couche de silicium ayant une épaisseur prédéterminée (pouvant varier entre 5 nm à 600 nm, voir plus épais en fonction de l'application visée) pourrait ainsi servir pour former des composants micro-électronique et ainsi permettre la co-intégration de composants à base de matériaux GaAs dans un même substrat.

Ainsi après avoir élaboré par épitaxie la couche monocristalline (3001, 3002, 3003) on pourrait aussi imaginer un assemblage de cette structure sur un substrat final et démonter au niveau de l'interface démontable 40 une partie du substrat support 100". Le substrat final peut ainsi fournir des fonctionnalités supplémentaires qui sont par exemple incompatibles avec des paramètres de la croissance effectuée auparavant (par exemple substrat final de type plastique flexible ou encore substrat final comportant des lignes métalliques). Par ailleurs et de manière générale l'interface démontable ne se situe pas forcément à l'intérieur du substrat support mais peut également se trouver à l'interface avec la couche germe de matériau SrTiO₃ assemblée sur ce substrat support comme déjà décrit en lien avec la figure 3.

## Revendications

1. Procédé de fabrication d'une couche monocristalline (300, 300', 3001, 3002, 3003) de matériau GaAs comprenant le transfert d'une couche germe monocristalline (200, 200', 2000') de matériau SrTiO₃ sur un substrat support (100, 100', 100") de matériau silicium suivi d'une croissance par épitaxie de la couche monocristalline (300, 300', 3001, 3002, 3003) de matériau GaAs, dans lequel le transfert de la couche germe monocristalline (200, 200', 2000') de matériau SrTiO₃ sur le substrat support (100, 100', 100") de matériau silicium comprend une étape d'assemblage (1, 1', 1") d'un substrat monocristallin (20, 20', 2001, 2002, 2003) de matériau SrTiO₃ sur le substrat support (100, 100', 100") suivi d'une étape d'amincissement (2', 2", 2"') dudit substrat monocristallin (20, 20', 2001, 2002, 2003) de matériau SrTiO₃

2. Procédé selon la revendication précédente dans lequel la couche germe monocristalline (200, 200', 2000') a une épaisseur inférieure à 10 µm, de préférence inférieure à 2 µm, et plus préférentiellement inférieure à 0,2µm.

3. Procédé selon la revendication précédente dans lequel l'étape d'amincissement (2") comprend la formation d'une zone de fragilisation délimitant une portion (200') du substrat monocristallin (20') de matériau SrTiO₃ destinée à être transférée sur le substrat support (100, 100', 100") de matériau silicium.

4. Procédé selon la revendication précédente dans lequel la formation de la zone de fragilisation est obtenue par implantation (0") d'espèces atomiques et/ou ioniques.

5. Procédé selon les revendications précédentes 3 à 4 dans lequel l'étape d'amincissement (2") comprend un détachement au niveau de la zone de fragilisation de manière à transférer ladite portion (200') du substrat monocristallin (20') de matériau SrTiO₃ sur le substrat support (100, 100', 100") de matériau silicium, en particulier le détachement comprend l'application d'une contrainte thermique et/ou mécanique.

6. Procédé selon les revendications précédentes 3 à 5 dans lequel l'étape d'assemblage (1', 1", 1‴) est une étape d'adhésion moléculaire.

7. Procédé selon l'une des revendications précédentes dans lequel la couche de germe monocristalline (200, 200', 2000') de matériau SrTiO₃ se présente sous la forme d'une pluralité de pavés (2001', 2002', 2003') transférés chacun sur le substrat support (100, 100', 100") de matériau silicium.

8. Procédé selon l'une des revendications précédentes dans lequel le substrat support (100, 100', 100") de matériau silicium comprend une interface démontable (40, 40') configurée pour être démontée par une attaque chimique et/ou par une sollicitation mécanique.

## Patentansprüche

1. Verfahren zur Herstellung einer einkristallinen Schicht (300, 300', 3001, 3002, 3003) aus GaAs-Material, umfassend den Transfer einer einkristallinen Keimschicht (200, 200', 2000') aus SrTiO₃-Material auf ein Trägersubstrat (100, 100', 100") aus Siliziummaterial, gefolgt von einem epitaktischen Wachstum der einkristallinen Schicht (300, 300', 3001, 3002, 3003) aus GaAs-Material, wobei der Transfer der einkristallinen Keimschicht (200, 200', 2000') aus SrTiO₃-Material auf das Trägersubstrat (100, 100', 100") aus Siliziummaterial einen Zusammenfügungsschritt (1, 1', 1") eines einkristallinen Substrats (20, 20', 2001, 2002, 2003) aus SrTiO₃-Material auf dem Trägersubstrat (100, 100', 100"), gefolgt von einem Ausdünnungsschritt (2', 2", 2"') des genannten einkristallinen Substrats (20, 20', 2001, 2002, 2003) aus SrTiO₃-Material, umfasst.

2. Verfahren nach dem vorhergehenden Anspruch, wobei die einkristalline Keimschicht (200, 200', 2000') eine Dicke von weniger als 10 µm, vorzugsweise weniger als 2 µm und besonders bevorzugt weniger als 0,2 µm aufweist.

3. Verfahren nach dem vorhergehenden Anspruch, wobei der Ausdünnungsschritt (2") die Bildung einer Versprödungszone umfasst, die einen Abschnitt (200') des einkristallinen Substrats (20') aus SrTiO₃-Material begrenzt, der auf das Trägersubstrat (100, 100', 100") aus Siliziummaterial übertragen werden soll.

4. Verfahren nach dem vorhergehenden Anspruch, wobei die Bildung der Versprödungszone durch Implantation (0") von atomaren und/oder ionischen Spezies erreicht wird.

5. Verfahren nach den vorhergehenden Ansprüchen 3 bis 4, wobei der Ausdünnungsschritt (2") ein Ablösen im Bereich der Versprödungszone umfasst, so dass der genannte Abschnitt (200') des einkristallinen Substrats (20') aus SrTiO₃-Material auf das Trägersubstrat (100, 100', 100") aus Siliziummaterial übertragen wird, wobei insbesondere das Ablösen die Anwendung einer thermischen und/oder mechanischen Belastung umfasst.

6. Verfahren nach den vorhergehenden Ansprüchen 3 bis 5, wobei der Zusammenfügungsschritt (1', 1", 1‴) ein molekularer Adhäsionsschritt ist.

7. Verfahren nach einem der vorhergehenden Ansprüche, wobei die einkristalline Keimschicht (200, 200', 2000') aus SrTiO₃-Material als eine Vielzahl von Blöcken (2001', 2002', 2003') vorliegt, die jeweils auf das Trägersubstrat (100, 100', 100") aus Siliziummaterial transferiert werden.

8. Verfahren nach einem der vorhergehenden Ansprüche, wobei das Trägersubstrat (100, 100', 100") aus Siliziummaterial eine demontierbare Schnittstelle (40, 40') umfasst, die derart ausgestaltet ist, dass sie durch einen chemischen Angriff und/oder durch eine mechanische Belastung demontiert werden kann.

## Claims

1. A method of manufacturing a single-crystal layer (300, 300', 3001, 3002, 3003) of GaAs material, comprising the transfer of a single-crystal seed layer (200, 200', 2000') of SrTiO₃ material onto a carrier substrate (100, 100', 100") of silicon material followed by epitaxial growth of the single-crystal layer (300, 300', 3001, 3002, 3003) of GaAs material, wherein the transfer of the single-crystal seed layer (200, 200', 2000') of SrTiO₃ material on the carrier substrate (100, 100', 100") of silicon material comprises a step of assembling (1, 1', 1") a single-crystal substrate (20, 20', 2001, 2002, 2003) of SrTiO₃ material on the carrier substrate (100, 100', 100"), followed by a step of thinning (2', 2", 2"') said single-crystal substrate (20, 20', 2001, 2002, 2003) of SrTiO₃ material.

2. The method according to the preceding claim, wherein the single-crystal seed layer (200, 200', 2000') has a thickness of less than 10 µm, preferably less than 2 µm, and more preferably less than 0.2 µm.

3. The method according to the preceding claim, wherein the thinning step (2") comprises the formation of an embrittlement zone defining a portion (200') of the single-crystal substrate (20') of SrTiO₃ material to be transferred onto the carrier substrate (100, 100', 100") of silicon material.

4. The method according to the preceding claim, wherein the formation of the embrittlement zone is achieved by implantation (0") of atomic and/or ionic species.

5. The method according to the preceding claims 3 to 4, wherein the thinning step (2") comprises a separation at the embrittlement zone so as to transfer said portion (200') of the single-crystal substrate (20') of SrTiO₃ material onto the carrier substrate (100, 100', 100") of silicon material, in particular the separation comprises the application of thermal and/or mechanical stress.

6. The method according to the preceding claims 3 to 5, wherein the assembly step (1', 1"), 1") is a molecular adhesion step.

7. The method according to one of the preceding claims, wherein the single-crystal seed layer (200, 200', 2000') of SrTiO₃ material is in the form of a plurality of blocks (2001', 2002', 2003') each transferred onto the carrier substrate (100, 100', 100") of silicon material.

8. The method according to one of the preceding claims, wherein the carrier substrate (100, 100', 100") of silicon material comprises a dismountable interface (40, 40') configured to be dismounted by chemical action and/or mechanical stress.
